(19) **Europäisches Patentamt / European Patent Office / Office européen des brevets**

(11) **EP 4 461 844 A1**

(12) **EUROPEAN PATENT APPLICATION**
published in accordance with Art. 153(4) EPC

(43) Date of publication:
**13.11.2024 Bulletin 2024/46**

(21) Application number: **22917654.0**

(22) Date of filing: **21.11.2022**

(51) International Patent Classification (IPC):
**C23C 14/08** (2006.01)  **C23C 14/34** (2006.01)

(52) Cooperative Patent Classification (CPC):
**C23C 14/08; C23C 14/34**

(86) International application number:
**PCT/JP2022/043060**

(87) International publication number:
**WO 2023/132144 (13.07.2023 Gazette 2023/28)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **05.01.2022 JP 2022000584**

(71) Applicant: **JX Advanced Metals Corporation Tokyo 105-8417 (JP)**

(72) Inventors:
• **YAMAMOTO, Hiroyoshi**
  **Kitaibaraki-shi, Ibaraki 319-1535 (JP)**
• **NARA, Atsushi**
  **Kitaibaraki-shi, Ibaraki 319-1535 (JP)**

(74) Representative: **Forresters IP LLP**
  **Skygarden**
  **Erika-Mann-Straße 11**
  **80636 München (DE)**

(54) **OXIDE FILM AND OXIDE SPUTTERING TARGET**

(57)    An object of the present disclosure is to provide an oxide film having low carrier concentration and high carrier mobility, and an oxide sputtering target suitable for forming such an oxide film. An oxide film containing zinc (Zn), tin (Sn), aluminum (Al), and oxygen (O), wherein the oxide film satisfies Formulas (1) to (3) below; provided that, in each of the following formulas, Al, Sn, and Zn respectively represent an atomic ratio of each element in the oxide film.

$$(1)\ 3 \times Sn/Zn < Al$$

$$(2)\ Al/(Al+Sn+Zn) \leq 0.10$$

$$(3)\ 0.33 \leq Sn/(Sn+Zn) \leq 0.60$$

EP 4 461 844 A1

**Description**

[Technical Field]

The present disclosure relates to an oxide film and an oxide sputtering target.

[Background Art]

A Zn-Sn-O system (ZTO: Zinc-Tin-Oxide) is known as a material of transparent conductive films and oxide semiconductor films. A transparent conductive film is used, for example, in solar batteries, liquid crystal surface devices, touch panels and the like (Patent Document 1 and so on). Moreover, an oxide semiconductor film is used as a semiconductor layer (channel layer) of thin film transistors (TFT) (Patent Document 2 and so on). A ZTO-based film is normally deposited using a sputtering target made from a Zn-Sn-O-based oxide sintered body.

A Zn-Sn-O-based oxide film to which other metal elements are added is known. For example, Patent Documents 3 and 4 disclose the formation of a thin film using an oxide sputtering target prepared from zinc oxide, gallium oxide, and tin oxide. Patent Document 3 describes that its object is to prepare a sputtering target having low bulk resistance and high density, and provide a transparent amorphous oxide semiconductor film in which selective etching to a metallic thin film is possible.

[Prior Art Documents]

[Patent Documents]

[Patent Document 1] Japanese Unexamined Patent Application Publication No. 2017-36198
[Patent Document 2] Japanese Unexamined Patent Application Publication No. 2010-37161
[Patent Document 3] Japanese Unexamined Patent Application Publication No. 2010-18457
[Patent Document 4] Japanese Unexamined Patent Application Publication (Translation of PCT Application) No. 2016-507004

[Disclosure of the Invention]

[Problems to be Solved by the Invention]

With an oxide semiconductor film, there are demands for increasing carrier mobility in order to increase response speed. Carrier mobility has a positive correlation with carrier concentration, and higher the carrier concentration, higher the carrier mobility. Thus, while it is conceivable to increase the carrier concentration in order to increase the carrier mobility, if the carrier concentration is increased, there is a problem in that the power consumption will also increase. In recent years, the issue of power consumption has become notable pursuant to the miniaturization of semiconductor devices, and there are demands for reducing power consumption. Nevertheless, because there is a trade-off relationship between carrier mobility and power consumption, it is necessary to satisfy both carrier mobility and power consumption.

When a ZTO film is used as an oxide semiconductor film, there was a problem in that the power consumption is high due to the high carrier concentration. Thus, it is conceivable to lower the carrier concentration by adjusting the film composition. Nevertheless, when the carrier concentration is decreased, the carrier mobility will also decrease, and there was a problem in that the intended semiconductor properties could not be obtained.

In light of the foregoing circumstances, an object of the present disclosure is to provide an oxide film having low carrier concentration and high carrier mobility, and an oxide sputtering target suitable for forming such an oxide film.

[Means for Solving the Problems]

One mode of the present disclosure capable of achieving the foregoing object is as shown below.

[1] An oxide film containing zinc (Zn), tin (Sn), aluminum (Al), and oxygen (O), wherein the oxide film satisfies Formulas (1) to (3) below; provided that, in each of the following formulas, Al, Sn, and Zn respectively represent an atomic ratio of each element in the oxide film.

$$(1)\ 3 \times Sn/Zn < Al$$

$$(2)\ Al/(Al+Sn+Zn) \le 0.10$$

$$(3)\ 0.33 \le Sn/(Sn+Zn) \le 0.60$$

[2] The oxide film according to [1] above, wherein the oxide film has a carrier mobility of 5.0 cm$^2$/V•s or more.

[3] The oxide film according to [1] or [2] above, wherein the oxide film has a carrier concentration of $1.0 \times 10^{18}$ cm$^{-3}$ or less.

[4] The oxide film according to any one of [1] to [3] above, wherein the oxide film has a refractive index of 2.15 or less.

[5] The oxide film according to any one of [1] to [4] above, wherein the oxide film has an extinction coefficient of 0.02 or less.

[6] An oxide sputtering target containing zinc (Zn), tin (Sn), aluminum (Al), and oxygen (O), wherein the oxide sputtering target satisfies Formulas (4) to (6) below; provided that, in each of the following formulas, Al, Sn, and Zn respectively represent an atomic ratio of each element in the oxide film.

$$(4)\ 3 \times Sn/Zn < Al$$

$$(5)\ Al/(Al+Sn+Zn) \le 0.10$$

$$(6)\ 0.33 \le Sn/(Sn+Zn) \le 0.50$$

[7] The oxide sputtering target according to [6] above, wherein the oxide sputtering target has a relative density of 97% or higher.

[8] The oxide sputtering target according to [6] or [7] above, wherein the oxide sputtering target has an average crystal grain size of 10 $\mu$m or less.

[9] The oxide sputtering target according to any one of [6] to [8] above, wherein the oxide sputtering target has a volume resistivity of 10 $\Omega$•cm or less.

[Effect of the Invention]

According to the present disclosure, it is possible to yield a superior effect of being able to provide an oxide film having low carrier concentration and high carrier mobility. Moreover, according to the present disclosure, it is possible to yield a superior effect of being able to provide an oxide sputtering target suitable for forming an oxide semiconductor film having low carrier concentration and high carrier mobility.

The object and effect of the present disclosure are not limited to those specifically described above, and include those that will become apparent to those skilled in the art from the entire specification.

[Best Mode for Carrying Out the Invention]

[Oxide film]

An oxide film according to an embodiment the present disclosure contains zinc (Zn), tin (Sn), aluminum (Al), and oxygen (O), and satisfies Formulas (1) to (3) below; provided that, in each of the following formulas, Al, Sn, and Zn respectively represent an atomic ratio of each element in the oxide film.

$$(1)\ 3 \times Sn/Zn < Al$$

$$(2)\ Al/(Al+Sn+Zn) \le 0.10$$

$$(3)\ 0.33 \le Sn/(Sn+Zn) \le 0.60$$

The oxide film according to this embodiment is an oxide film obtained by adding Al to ZTO (sometimes referred to as "AZTO"). As a result of including a predetermined amount of Al in the oxide film, it is possible to increase the carrier mobility while preventing the increase in the carrier concentration. With the oxide film according to this embodiment, the Al content is changed depending on the Sn/Zn relationship. This is because, when the Sn content is increased, the effect of Al will weaken and the carrier concentration will increase, and as a result the power consumption will increase more than anticipated. Specifically, the lower limit of the Al content is set to $3 \times$ Sn/Zn < Al.

In the oxide film according to this embodiment, the upper limit of the Al content is Al/(Al+Sn+Zn) $\leq$ 0.10. This is because, if Al/(Zn+Sn+Al) exceeds 0.10, there is a problem in that the resistivity of the oxide film will become too high.

In the oxide film according to this embodiment, the content ratio of Sn and Zn is $0.33 \leq$ Sn/(Sn+Zn) $\leq$ 0.60. If Sn/(Sn+Zn) is 0.33 or higher, variations in the film characteristics (carrier concentration, mobility, volume resistivity and the like) due to heat can be suppressed to be within a certain range upon annealing the film. Moreover, if Sn/(Sn+Zn) is 0.60 or less, the carrier concentration can be maintained low.

With the oxide film according to this embodiment, the carrier mobility is preferably 5.0 $cm^2$/V•s or more, more preferably 10.0 $cm^2$/V•s or more, and most preferably 12.0 $cm^2$/V•s or more. The carrier mobility is preferably high in order to increase the response speed of the oxide film, and if the mobility is within the foregoing range, the intended semiconductor properties can be obtained.

With the oxide film according to this embodiment, the carrier concentration is preferably $1.0 \times 10^{18}$ $cm^{-3}$ or less, more preferably $1.0 \times 10^{17}$ $cm^{-3}$ or less, and most preferably $1.0 \times 10^{16}$ $cm^{-3}$ or less. Because the carrier concentration has a positive correlation with the carrier mobility, the carrier concentration is ideally high, but if the carrier concentration is too high, there is a problem in that the power consumption will increase. Accordingly, by adjusting the carrier concentration to fall within the foregoing range, the power consumption can be sufficiently reduced.

With the oxide film according to this embodiment, the refractive index of light having a wavelength of 405 nm is preferably 2.00 or more and 2.15 or less. As a result of causing the refractive index to fall within the foregoing numerical range, it is possible to yield the effect of preventing scattering caused by the mediums, and this is effective as a transparent conductive film.

With the oxide film according to this embodiment, the extinction coefficient of light having a wavelength of 405 nm is preferably 0.02 or less. As a result of causing the extinction coefficient to fall within the foregoing numerical range, it is possible to yield the effect of achieving high transparency, and this is effective as a transparent conductive film.

[Oxide sputtering target]

With the sputtering method, because the film is deposited in a vacuum, the composition of the sputtering target (atomic ratio of metal components) is reflected in the film composition without any partial loss of the metal components configuring the sputtering target or the inclusion of other metal components during the deposition process. Thus, under normal circumstances, the composition of the sputtering target may be adjusted to match the intended film composition. Nevertheless, because the sputter rate varies depending on the constituent elements and crystal phase, it is necessary to decide the composition of the sputtering target in consideration of such variation.

The oxide sputtering target according to this embodiment contains zinc (Zn), tin (Sn), aluminum (Al), and oxygen (O), and satisfies Formulas (4) to (6) below; provided that, in each of the following formulas, Al, Sn, and Zn respectively represent an atomic ratio of each element in the oxide film.

$$(4) \ 3 \times \text{Sn/Zn} < \text{Al}$$

$$(5) \ \text{Al/(Al+Sn+Zn)} \leq 0.10$$

$$(6) \ 0.33 \leq \text{Sn/(Sn+Zn)} \leq 0.50$$

Formulas (4) and (5) may be adjusted to have the same composition as the respective metal elements in the oxide semiconductor film. Meanwhile, with Formula (6), because the sputter rate of Zn is slower than that of Sn, the upper limit of Sn/(Sn+Zn) needs to be adjusted to Sn/(Sn+Zn) $\leq$ 0.50.

With the oxide sputtering target according to this embodiment, the relative density is preferably 97% or higher, more preferably 98% or higher, and most preferably 99% or higher. A high density sputtering target can reduce the amount of particles that are generated during deposition.

The relative density is calculated based on the following formula. Relative density (%) = (measured density)/(standard density) $\times$ 100

The standard density is the value of density calculated from the theoretical density and mass ratio of the oxides of elements excluding oxygen in the respective constituent elements of the sputtering target, and the theoretical density of each oxide is as follows.

Theoretical density of $Al_2O_3$: 3.95 g/cm$^3$
Theoretical density of SnO: 6.95 g/cm$^3$
Theoretical density of ZnO: 5.61 g/cm$^3$

The measured density is the value obtained by dividing the weight of the sputtering target by its volume, and is calculated using the Archimedes method.

With the oxide sputtering target according to this embodiment, the average crystal grain size is preferably 10 $\mu$m or less, and more preferably 5 $\mu$m or less. When the texture of the sputtering target is fine, the amount of particles that are generated during deposition can be reduced.

With the sputtering target according to this embodiment, the volume resistivity is preferably 10 $\Omega\cdot$cm or less, and more preferably 5 $\Omega\cdot$cm or less. When the volume resistivity of the sputtering target is low, deposition can be performed stably during DC (direct current) sputtering.

[Production method of oxide sputtering target]

The oxide sputtering target according to this embodiment can be produced, for example, in the following manner. Nevertheless, the following production method is merely illustrative, and it should be understood that this embodiment is not limited to this production method. Moreover, the detailed explanation of known processes is omitted to avoid the production method from becoming unnecessarily unclear.

(Mixing and pulverization of raw materials)

As raw materials, a ZnO powder, a SnO powder and an $Al_2O_3$ powder are prepared, and these raw materials are weighed and mixed to obtain the intended compound ratio, and then pulverized. After pulverization, the resulting average particle diameter (D50) is preferably 1.5 $\mu$m or less.

(Calcination of mixed powder)

The pulverized mixed powder is calcined at 1000°C to 1300°C for 4 to 7 hours. As a result of performing calcination, a composite oxide ($Zn_2SnO_4$ phase, $ZnAl_2O_4$ phase) can be obtained. Nevertheless, calcination is an arbitrary process.

(Hot press sintering)

The thus obtained mixed powder or calcined powder is filled in a carbon mold, and subject to pressure sintering (hot press) in a vacuum or inert gas atmosphere. The hot press conditions are preferably set as follows; namely, sintering temperature of 950°C to 1100°C, applied pressure of 200 to 300 kgf/cm$^2$, and holding time of 1 to 4 hours. This is because, when the sintering temperature is too low, a high density sintered body cannot be obtained, and when the sintering temperature is too high, compositional variation caused by the evaporation of ZnO will occur.

(Surface finishing)

By preparing an oxide sintered body based on the foregoing processes and subsequently subjecting the oxide sintered body to machining processes such as cutting and grinding, an oxide sputtering target can be produced.

(Deposition)

By mounting a sputtering target on a deposition device and performing sputtering under the following conditions, an oxide semiconductor film can be deposited on a substrate. Nevertheless, the following deposition conditions are representative examples, and it should be understood that there is no intention of limiting the present disclosure to these deposition conditions.

Deposition principle: DC sputtering
Deposition device: ANELVASPL-500
Target size: Diameter 6 inches, thickness 5 mm

Substrate: Glass
Film thickness: 60 to 900 nm
Power: 2.74 to 5.48 W/cm$^2$
Atmosphere: Ar+2%$O_2$, 0.5 Pa, 28 to 50 sccm

[Examples]

The present invention is now explained based on the following Examples and Comparative Examples. Note that the following Examples are merely representative examples, and the present invention is not limited to these Examples in any way. In other words, the present invention is limited only based on the scope of its claims, and covers various modifications other than the Examples included in the present invention.

In the present disclosure, the various physical properties, including those of the Examples and Comparative Examples, were analyzed using the following measurement methods and measurement conditions.

(Component composition of film)

Measuring principle: FE-EPMA quantitative analysis
Measuring device: JXA-8500F manufactured by JEOL
Measurement condition: Acceleration voltage 15 kV
Illumination current: $2 \times 10^{-7}$A
Beam diameter: 100 $\mu$m

(Carrier concentration of film)

Measuring principle: Hall measurement
Measuring device: 8400 model manufactured by LakeShore
Measurement condition: Sample was measured after being annealed at 200°C

(Carrier mobility of film)

Measuring principle: Hall measurement
Measuring device: 8400 model manufactured by LakeShore
Measurement condition: Sample was measured after being annealed at 200°C

(Component composition of sputtering target)

Method: ICP-OES (Inductively Coupled Plasma Optical Emission Spectrometry)
Device: SPS3500DD manufactured by SII

(Volume resistivity of sputtering target)

Measuring device: Resistivity meter Σ-5+
Measurement system: Constant current application system
Measurement method: DC four probe method

The volume resistivity was measured at one location at the center and four locations at 90-degree intervals near the outer periphery on the surface of the sputtering target, and the average value thereof was obtained.

(Examples 1 to 5)

A ZnO powder, a SnO powder and an $Al_2O_3$ powder were prepared, these raw materials were blended to achieve the composition ratio of the sputtering target indicated in Table 1, and thereafter mixed. The thus obtained mixed powder was pulverized via wet pulverization ($ZrO_2$ beads were used) to achieve an average particle diameter (D50) of 1.5 $\mu$m or less, dried, and thereafter sieved using a sieve having a sieve opening of 500 $\mu$m.

Next, the pulverized powder was filled in a carbon mold, subject to hot press sintering under the conditions described in Table 1, and the thus obtained sintered body was machined to obtain a shape of a sputtering target (diameter of 6 inches).

The relative density, average crystal grain size and volume resistivity of the Zn-Sn-Al-O (AZTO) oxide sputtering target prepared above were measured. The results are shown in Table 1. As shown in Table 1, favorable results were obtained for all Examples 1 to 5 regarding relative density, average crystal grain size, and volume resistivity. Moreover, as a result of performing DC sputtering using this sputtering target, arcing did not occur during sputtering, and it was possible to perform sputtering stably.

[Table 1]

| | Composition of Sputtering Target [Metallic Atom %] | | | | | | | | Sintering Conditions | | | | Theoretical Density | Archimedes Density | Relative Density | Average Grain Size | Volume Resistivity |
|---|---|---|---|---|---|---|---|---|---|---|---|---|---|---|---|---|---|
| | Al | Zn | Sn | Total | Al/(Al+Zn+-Sn) | 3*Sn/-Zn | Sn/(Al+Zn+-Sn) | Sn/(Zn+-Sn) | Surface Pressure (kgf/cm$^2$) | Temperature | Atmosphere | Press Time (Hours) | [g/cm$^3$] | [g/cm$^3$] | [%] | [μm] | [Ω·cm] |
| Example 1 | 5 | 63 | 32 | 100 | 0.05 | 1.52 | 0.32 | 0.34 | 250 | 1050°C | Argon | 2 | 6.10 | 6.09 | 99.9 | 4.0 | 2.47 |
| Example 2 | 5 | 63 | 32 | 100 | 0.05 | 1.52 | 0.32 | 0.34 | 250 | 1000°C | Argon | 2 | 6.10 | 6.25 | 102.4 | 4.6 | 0.29 |
| Example 3 | 10 | 45 | 45 | 100 | 0.10 | 3.00 | 0.45 | 0.50 | 250 | 1050°C | Argon | 2 | 6.18 | 6.35 | 102.8 | 2.5 | 0.01 |
| Example 4 | 5 | 57 | 38 | 100 | 0.05 | 2.00 | 0.38 | 0.40 | 250 | 1050°C | Argon | 2 | 6.19 | 6.13 | 99.0 | 3.6 | 0.48 |
| Example 5 | 5 | 48 | 48 | 100 | 0.05 | 3.00 | 0.48 | 0.50 | 250 | 1050°C | Argon | 2 | 6.32 | 6.20 | 98.1 | 3.3 | 0.45 |

(Examples 6 to 17)

A ZnSnO sputtering target and an $Al_2O_3$ sputtering target were prepared using the powder sintering method. These sputtering targets were mounted on a sputter device and simultaneous sputtering (co-sputtering) was performed to deposit a film. Note that the adjustment of the Al concentration in the film was performed by changing the sputter power applied to the ZnSnO and $Al_2O_3$ sputtering targets. The concentration adjustment of Zn and Sn in the film was performed by using four types of ZnSnO sputtering targets having different compositions.

As the four types of ZnSnO sputtering targets described above, the composition was changed in the following manner; specifically, Zn:Sn = 66.7 at%:33.3 at%, 60.0 at%:40.0 at%, 50.0 at%:50.0 at%, and 40 at%:60 at%.

The carrier concentration, carrier mobility, refractive index, and extinction coefficient of the films obtained in Examples 6 to 17 were analyzed. As a result, in all cases the carrier concentration was $1.0 \times 10^{18}$ cm$^{-3}$ or less and the carrier mobility was 10.0 cm$^2$/V•s or more, and the intended results were obtained. Moreover, in all cases the refractive index was 2.15 or less and the extinction coefficient was 0.02 or less, and favorable results were obtained. These results are shown in Table 2. Note that, while the refractive index and the extinction coefficient were not measured in Examples 6 to 11, it can be assumed that in all cases the refractive index satisfies 2.15 or less and the extinction coefficient satisfies 0.02 or less.

[Table 2]

| | Film Composition [Metallic Atom %] Measured Value | | | | | | | Mobility [cm$^2$/V·s] | Carrier Concentration | Refractive Index [n] | Extinction Coefficient |
|---|---|---|---|---|---|---|---|---|---|---|---|
| | Al | Zn | Sn | Total | 3*Sn/Zn | Al/(Al+Zn+Sn) | Sn/(Zn+Sn) | | | | |
| Example 6 | 7 | 55 | 38 | 100 | 2.09 | 0.07 | 0.41 | 10.8 | 3.7E+16 | - | - |
| Example 7 | 3 | 58 | 39 | 100 | 2.02 | 0.03 | 0.40 | 18.4 | 1.4E+17 | - | - |
| Example 8 | 4 | 58 | 38 | 100 | 1.97 | 0.04 | 0.40 | 17.2 | 6.9E+16 | - | - |
| Example 9 | 5 | 57 | 38 | 100 | 2.00 | 0.05 | 0.40 | 16.2 | 3.1E+16 | - | - |
| Example 10 | 6 | 57 | 37 | 100 | 1.95 | 0.06 | 0.39 | 14.3 | 2.6E+16 | - | - |
| Example 11 | 8 | 56 | 36 | 100 | 1.93 | 0.08 | 0.39 | 12.9 | 6.0E+15 | - | - |
| Example 12 | 3 | 51 | 46 | 100 | 2.71 | 0.03 | 0.47 | 17.0 | 8.1E+17 | 2.10 | 0.013 |
| Example 13 | 8 | 46 | 46 | 100 | 2.96 | 0.08 | 0.50 | 12.5 | 1.0E+17 | 2.11 | 0.008 |
| Example 14 | 9 | 48 | 43 | 100 | 2.66 | 0.09 | 0.47 | 9.9 | 8.6E+14 | 2.10 | 0.006 |
| Example 15 | 5 | 41 | 54 | 100 | 4.00 | 0.05 | 0.57 | 14.0 | 2.9E+16 | 2.12 | 0.009 |
| Example 16 | 6 | 40 | 54 | 100 | 4.04 | 0.06 | 0.57 | 12.6 | 4.4E+17 | 2.12 | 0.010 |
| Example 17 | 9 | 38 | 52 | 100 | 4.11 | 0.10 | 0.58 | 11.3 | 1.2E+17 | 2.09 | 0.006 |
| Comparative Example 1 | 1 | 52 | 47 | 100 | 2.71 | 0.01 | 0.47 | 20.5 | 2.3E+18 | 2.12 | 0.017 |
| Comparative Example 2 | 3 | 42 | 55 | 100 | 3.93 | 0.03 | 0.57 | 16.1 | 2.7E+18 | - | - |
| Comparative Example 3 | 0 | 30 | 70 | 100 | 7.00 | 0.00 | 0.70 | 7.2 | 1.6E+19 | 2.18 | 0.052 |
| Comparative Example 4 | 0 | 43 | 57 | 100 | 3.98 | 0.00 | 0.57 | 14.0 | 1.1E+19 | 2.11 | 0.028 |
| Comparative Example 5 | 0 | 54 | 46 | 100 | 2.56 | 0.00 | 0.46 | 19.7 | 5.5E+18 | 2.12 | 0.020 |

(Comparative Examples 1 to 5)

In Comparative Examples 1 to 5, a ZnSnO sputtering target and an $Al_2O_3$ sputtering target were mounted on a sputter device and simultaneous sputtering (co-sputtering) was performed to deposit a film as with Example 6. The Al concentration in the film and the concentration ratio of Zn and Sn in the film were adjusted in the same manner as with Example 6. The composition of the films of Comparative Examples 1 to 5 is shown in Table 2.

The carrier concentration, carrier mobility, refractive index, and extinction coefficient of the films obtained in Comparative Examples 1 to 5 were analyzed. As a result, the films of Comparative Examples 1 to 5 had high carrier mobility on the one hand, but also had high carrier concentration on the other hand.

[Industrial Applicability]

According to the present disclosure, it is possible to yield a superior effect of being able to provide an oxide film having low carrier concentration and high carrier mobility. Moreover, according to the present disclosure, it is possible to yield a superior effect of being able to provide an oxide sputtering target suitable for forming an oxide film having low carrier concentration and high carrier mobility. The oxide film according to the present invention is useful as a transparent conductive film of solar batteries, liquid crystal surface devices and touch panels, and as a semiconductor film for use as a TFT channel layer.

**Claims**

1. An oxide film containing zinc (Zn), tin (Sn), aluminum (Al), and oxygen (O), wherein the oxide film satisfies Formulas (1) to (3) below; provided that, in each of the following formulas, Al, Sn, and Zn respectively represent an atomic ratio of each element in the oxide film.

$$(1)\ 3 \times Sn/Zn < Al$$

$$(2)\ Al/(Al+Sn+Zn) \leq 0.10$$

$$(3)\ 0.33 \leq Sn/(Sn+Zn) \leq 0.60$$

2. The oxide film according to claim 1, wherein the oxide film has a carrier mobility of 5.0 $cm^2/V{\cdot}s$ or more.

3. The oxide film according to claim 1 or claim 2, wherein the oxide film has a carrier concentration of $1.0 \times 10^{18}\ cm^{-3}$ or less.

4. The oxide film according to any one of claims 1 to 3, wherein the oxide film has a refractive index of 2.15 or less.

5. The oxide film according to any one of claims 1 to 4, wherein the oxide film has an extinction coefficient of 0.02 or less.

6. An oxide sputtering target containing zinc (Zn), tin (Sn), aluminum (Al), and oxygen (O), wherein the oxide sputtering target satisfies Formulas (4) to (6) below; provided that, in each of the following formulas, Al, Sn, and Zn respectively represent an atomic ratio of each element in the oxide film.

$$(4)\ 3 \times Sn/Zn < Al$$

$$(5)\ Al/(Al+Sn+Zn) \leq 0.10$$

$$(6)\ 0.33 \leq Sn/(Sn+Zn) \leq 0.50$$

7. The oxide sputtering target according to claim 6, wherein the oxide sputtering target has a relative density of 97% or higher.

**8.** The oxide sputtering target according to claim 6 or claim 7, wherein the oxide sputtering target has an average crystal grain size of 10 $\mu$m or less.

**9.** The oxide sputtering target according to any one of claims 6 to 8, wherein the oxide sputtering target has a volume resistivity of 10 $\Omega$•cm or less.

## INTERNATIONAL SEARCH REPORT

International application No.

**PCT/JP2022/043060**

### A. CLASSIFICATION OF SUBJECT MATTER

***C23C 14/08***(2006.01)i; ***C23C 14/34***(2006.01)i

FI: C23C14/08 K; C23C14/34 A

According to International Patent Classification (IPC) or to both national classification and IPC

### B. FIELDS SEARCHED

Minimum documentation searched (classification system followed by classification symbols)

C23C14/08; C23C14/34

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2012-66968 A (KOBELCO KAKEN KK) 05 April 2012 (2012-04-05) claims, paragraphs [0001], [0029]-[0034], [0050]-[0053], example Al-ZTO | 1-7, 9 |
| Y | | 8 |
| X | JP 2012-33854 A (KOBE STEEL LTD) 16 February 2012 (2012-02-16) claims, paragraphs [0026]-[0033], [0050]-[0051], [0072]-[0078], no. 2-3 | 1-6 |
| Y | | 7-9 |
| X | JP 9-35535 A (SUMITOMO METAL MINING CO LTD) 07 February 1997 (1997-02-07) claims, paragraphs [0014]-[0016], table 1, example Sn/Zn=0.7, Al=3-4 atm% | 1-6 |
| Y | | 7-9 |
| X | CHANG, Chih-Hsiang et al. Investigation on plasma treatment for transparent Al-Zn-Sn-O thin film transistor application. Thin Solid Films. 04 July 2013, http://dx.doi.org/10.1016/j.tsf.2013.06.042 2. Experiment, 3. Result and discussions, Fig. 2 | 1-6 |
| Y | | 7-9 |

☑ Further documents are listed in the continuation of Box C.　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **31 January 2023** | **07 February 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**

| International application No. |
|---|
| **PCT/JP2022/043060** |

**C.    DOCUMENTS CONSIDERED TO BE RELEVANT**

| Category* | Citation of document, with indication, where appropriate, of the relevant passages | Relevant to claim No. |
|---|---|---|
| Y | JP 2007-223899 A (NIKKO KINZOKU KK) 06 September 2007 (2007-09-06)<br>        claims, paragraphs [0001], [0005] | 7-9 |
| Y | JP 2014-240525 A (JX NIPPON MINING & METALS CORP) 25 December 2014<br>(2014-12-25)<br>        claims, paragraphs [0001], [0006] | 7-9 |

Form PCT/ISA/210 (second sheet) (January 2015)

<table>
<tr><td colspan="2" align="center">INTERNATIONAL SEARCH REPORT<br>Information on patent family members</td><td colspan="2">International application No.<br><br>**PCT/JP2022/043060**</td></tr>
</table>

| Patent document<br>cited in search report | Publication date<br>(day/month/year) | Patent family member(s) | Publication date<br>(day/month/year) |
|---|---|---|---|
| JP 2012-66968 A | 05 April 2012 | WO 2012/039351 A1<br>claims, paragraphs [0001],<br>[0029]-[0034], [0050]-[0053],<br>examples Al-ZTO | |
| JP 2012-33854 A | 16 February 2012 | US 2013/0032798 A1<br>claims, paragraphs [0047]-<br>[0054], [0072], [0078], [0113]-<br>[0130], no. 2-3<br>WO 2011/132644 A1<br>CN 102859701 A<br>KR 10-2013-0018300 A | |
| JP 9-35535 A | 07 February 1997 | (Family: none) | |
| JP 2007-223899 A | 06 September 2007 | (Family: none) | |
| JP 2014-240525 A | 25 December 2014 | US 2015/0014155 A1<br>claims, paragraphs [0001],<br>[0008]<br>WO 2013/125259 A1<br>CN 104395497 A<br>JP 2016-121395 A1 | |

Form PCT/ISA/210 (patent family annex) (January 2015)

**REFERENCES CITED IN THE DESCRIPTION**

**Patent documents cited in the description**

- JP 2017036198 A
- JP 2010037161 A
- JP 2010018457 A
- JP 2016507004 W